# EUROPÄISCHE PATENTSCHRIFT

(11) **EP 0 742 594 B1**
(45) Veröffentlichungstag und Bekanntmachung des Hinweises auf die Patenterteilung: **23.06.1999**
(21) Anmeldenummer: 96107046.3
(22) Anmeldetag: 04.05.1996
(51) Int. Cl.: H01L 39/22

(54) **Hochtemperatur Supraleiter-Normalleiter-Supraleiter-(HTSL-SNS-) Kontakt, Verfahren zu seiner Herstellung sowie seiner Verwendung**
High temperature superconductor-normal-superconductor (HTSC-SNS) contact, method of making the same and its application
Contact supraconducteur-normal-supraconducteur à haute température (HTSC-SNS), procédé de sa fabrication et son application

(30) Priorität: 10.05.1995 DE 19516611
(43) Veröffentlichungstag der Anmeldung: 13.11.1996
(73) Patentinhaber: FORSCHUNGSZENTRUM JÜLICH GMBH, 52425 Jülich (DE)
(72) Erfinder: Bode, Michael, Dr., 52064 Aachen (DE); Siegel, Michael, Dr., 52355 Düren (DE)

(56) Entgegenhaltungen:
- EP-A- 0 496 259

## Beschreibung

Die Erfindung betrifft einen Supraleiter-Normalleiter-Supraleiter-Kontakt mit supraleitenden Bereichen aus Hochtemperatur-Supraleiter (HTSL)-Material, im folgenden als HTSL-SNS-Kontakt bezeichnet, gemäß dem Oberbegriff des Anspruchs 1. Desweiteren betrifft die Erfindung ein Verfahren zu seiner Herstellung und dessen Verwendung.

Die als Stand der Technik z.B. aus P.A. Rosenthal, E.N. Grossmann, R.H. Ono, L.R. Vale, Appl. Phys. Lett., Bd. 63, S. 1984-1986 (1993) bekannten SNS-Stufenkontakte mit supraleitenden Schichten aus HTSL-Material, im folgenden als S-Schichten bezeichnet, und einer normalleitenden Zwischenschicht sind Josephson-Kontakte mit dem bisher höchsten Wert I_{c}*Rₙ. Zur Bildung der normalleitenden Zwischenschicht, im folgenden N-Schicht genannt, werden Edelmetalle oder ihre Legierungen als Material eingesetzt. Damit sind diese Kontakte für einen Betrieb bis zu Frequenzen in den THz-Bereich einsetzbar. Diese SNS-Kontakte zeigen eine charakteristische Spannung von bis zu 10 mV bei 4,2 K . Dies entspricht etwa 50% des theoretisch erreichbaren Maximums.

Die Kontakte werden mit Hilfe einer Technologie hergestellt, die einen Einsatz in komplexen Schaltungen erheblich erschwert. Im einzelnen werden die beiden supraleitenden Elektroden des Kontaktes durch eine gerichtete, anisotrope Deposition der S-Schicht an einer steilen Stufe im Substrat getrennt. Durch die Schattenwirkung der Stufe während der Abscheidung gelangt kein supraleitendes Material auf die Stufenflanke, so daß auf diese Weise eine supraleitende Verbindung zwischen den beiden Elektroden vermieden wird.

Der Nachteil dieses Kontakttyps besteht darin, daß zur Bildung mehrerer Kontakte auf einem einzigen Substrat wegen der anisotropen Deposition alle diese Kontakte in der gleichen Richtung ausgerichtet sein müssen. Dies stellt eine Einschränkung im Schaltungsdesign dar, insbesondere dann wenn wegen besonderer schaltungstechnischer Vorgaben mehrere Kontakte auf engstem Raum gebildet werden sollen.

Es ist deshalb Aufgabe der Erfindung einen SNS-Kontakt, sowie ein Verfahren zur Herstellung eines solchen Kontaktes bereitzustellen, wobei die Orientierung des Kontaktes frei wählbar ist und damit nicht an eine bestimmte Anisotropie gebunden ist.

Die Aufgabe wird gelöst durch einen SNS-Kontakt gemäß der Gesamtheit der Merkmale nach Anspruch 1. Die Aufgabe wird ferner gelöst durch ein Verfahren gemäß der Gesamtheit der Merkmale nach Anspruch 3. Weitere zweckmäßige oder vorteilhafte Ausführungsformen oder Varianten finden sich in den auf jeweils einen dieser Ansprüche rückbezogenen Unteransprüchen.

Die Erfindung ist im weiteren an Hand von Figuren und Ausführungsbeispiel näher erläutert. Es zeigen:
- Fig. 1:: Schematische Darstellung des Aufbaus eines als Stand der Technik bekannten SNS-Kontaktes;
- Fig. 2:: Schematische Darstellung des Aufbaus des Stufenkontakts zur Erzeugung der zusätzlichen Schicht;
- Fig. 3:: Schematische Darstellung des Aufbaus des erfindungsgemäß ausgebildeten SNS-Kontaktes;

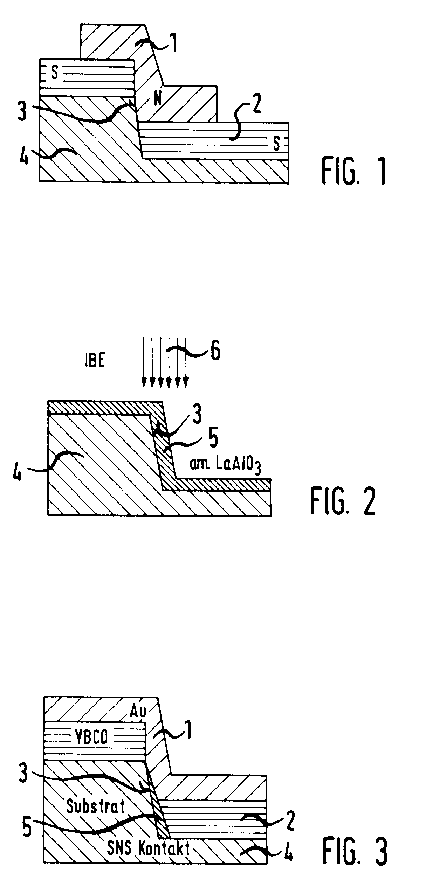

In Figur 1 ist der aus dem Stand der Technik bekannte SNS-Stufenkontakt mit aus HTSL hergestellten, in zwei voneinander über eine Stufe 3 getrennten S-Schichten 2 und einer N-Zwischenschicht 1 im Schnitt senkrecht zur Oberfläche eines Substrats 4 dargestellt. Die beiden supraleitenden Elektroden S bzw. 2 sind durch eine gerichtete, anisotrope Deposition an der steilen Stufe 3 im Substrat 4 getrennt.

In der Figur 2 ist im senkrechten Querschnitt eine schematische Darstellung des Aufbaus eines Stufenkontaktes 3 mit einer auf dem Substrat 4 gebildeten zusätzlichen Schicht 5, im folgenden I-Schicht 5 genannt, dargestellt.

Die Trennung der supraleitenden Elektroden 2 wird durch eine Bedeckung der Stufenflanke 3 mit einem Material I zur Bildung der Schicht 5 bewirkt, das das Aufwachsen einer supraleitenden Schicht auf der Flanke 3 verhindert. Es kommen sowohl Materialien in Frage, die den Supraleiter chemisch verändern (z.B. SiO), als auch solche, die eine Ausbildung der supraleitenden Kristallstruktur verhindern (z.B. amorphes oder polykristallines MgO, YBCO oder LaAlO₃). Der Kontakt zwischen den supraleitenden Elektroden wird durch eine N-Schicht 1, im Ausführungsbeispiel aus Gold (Au),hergestellt. Die Herstellung dieser Schicht 1 kann nach dem Abscheideprozeß der HTSL-Schicht in-situ mittels Sputtering oder Aufdampfen erfolgen. Im Ergebnis erhält man den SNS-Kontakt, wie in der Figur 3 dargestellt. Wie dargestellt, hat dabei die die Flanke 3 abdeckende Schicht 5 einen in etwa dreieckigen Querschnitt; sie kann aber auch anders ausgebildet sein, solange durch Abdeckung der Flanke 3 und durch Ausbildung einer für ein Wachstum des HTSL-Materials ungeeigneten Oberfläche dieser I-Schicht 5 dieses Wachstum verhindert und auf diese Weise bei HTSL-Deposition das Substrat 4 nur in zwei voneinander getrennten, zur Bildung der Elektroden vorgesehenen Substratbereichen mit HTSL beschichtet wird.

Die relativ dünne I-Schicht 5 wird auf das Substrat mit einer Dicke von 10 nm bis 20 nm aufgebracht, nachdem die Stufenstrukturierung erfolgt ist. Die Höhe der Stufe kann 200 nm bis 300 nm betragen. Das Material der I-Schicht wird anschließend mittels Ionenstrahlätzen 6 senkrecht zur Substratoberfläche wieder entfernt. Aufgrund der Winkelabhängigkeit der Ätzrate und des streifenden Einfalls auf der Stufenflanke bleibt auf der Flanke Material der I-Schicht zurück. Bei der anschließenden Deposition des HTSL-Supraleiters verhindert die I-Schicht einen supraleitenden Kontakt über die Stufe.

Der gesamte Herstellungsprozeß kann rotationssymmetrisch zur Normalen des Substrats durchgeführt werden. Auf diese Weise ergeben sich keine Einschränkungen bzgl. der Ausrichtung mehrerer SNS-Kontakte.

Es wurden Testproben mit kalt abgeschiedenem LaAlO₃ als Material für die I-Schicht hergestellt. Die supraleitende Schicht bestand aus 150nm dickem YBa₂Cu₃O₇, das in einem on-axis DC-Magnetron Sputterverfahren abgeschieden wurde. Selbstverständlich kommen auch andere Materialien zur Bildung der I-Schicht bzw. der S-Schicht in Betracht.

Zum Vergleich wurden bei 10 Testproben mit jeweils 30 Kontakten ohne Edelmetallfilm der elektrische Widerstand des jeweiligen Kontaktes bestimmt. Diese Kontakte zeigten selbst bei 4,2 K keine Supraleitung, sondern Widerstände im Bereich von 100 kOhm bis zu 1 MOhm.

Demgegenüber zeigten identisch hergestellte Proben mit den Stufenbereich zwischen den beiden S-Elektroden abdeckendem Edelmetallfilm kritische Ströme im Bereich von 200 µA bis 2 mA und Widerstände zwischen 0,5 Ohm und 2 Ohm.

Die vorliegende Erfindung beschreibt ein neues technologisches Verfahren zur Herstellung eines SNS-Stufenkontaktes mit Gold-Zwischenschicht, der die oben genannte Einschränkung beseitigt. Das erfindungsgemäße Verfahren gestattet die Anwendung völlig isotroper, technologischer Prozesse und ermöglicht damit eine beliebige Ausrichtung der Kontakte auf einem Substrat.

Selbstverständlich ist die Erfindung nicht nur auf die Ausbildung eines einzelnen SNS-Kontaktes anwendbar. Vielmehr kann man auf diese Weise auf einem einzigen Substrat 4 mehrere Stufen mit mehreren Flanken 3 vorsehen, so daß auf diese Weise Mehrfachkontakte gebildet werden können, wobei die Flanken 3 mit I-Schichten 5 jeweils entsprechend abgedeckt werden bzw. sind. Gegebenenfalls können die Stufenorientierungen innerhalb eines solchen Mehrfachkontaktes von Einzelkontakt zu Einzelkontakt je nach erwünschte Randbedingungen unterschiedlich gewählt und eingestellt werden.

## Patentansprüche

1. Supraleiter-Normalleiter-Supraleiter-(SNS)Kontakt mit supraleitenden Bereichen aus Hochtemperatur-Supraleiter (HTSL)-Material und mit einer metallischen Schicht (1), die zwei auf einem Substrat (4) über eine eine Flanke (3) aufweisende Substratstufe voneinander getrennte, als Elektroden wirkende, supraleitende Schichtbereiche (2) aus HTSL-Material miteinander verbindet, **dadurch gekennzeichnet, daß** die Flanke der Substratstufe (3) mit einer zusätzlichen Schicht (5) derart bedeckt ist, daß ein Aufwachsen von supraleitendem Material an der mit der zusätzlichen Schicht bedeckten Flanke (3) verhindert wird.

2. HTSL-SNS-Kontakt nach Anspruch 1, **dadurch gekennzeichnet, daß** als Material der metallischen Schicht (1) ein Edelmetall gewählt wird.

3. Verfahren zur Herstellung eines HTSL-SNS-Kontaktes nach Anspruch 1 oder 2, **dadurch gekennzeichnet, daß** an der Stufe des Substrats (4) im Bereich der Flanke (3) Material zur Bildung der zusätzlichen Schicht (5) aufgebracht wird, so daß die Flanke auf diese Weise von der zusätzlichen Schicht (5) abgedeckt wird , daß sodann dieses Material im Bereich der beiden, durch die schräge Flanke getrennten Substratbereiche teilweise entfernt wird, daß sodann HTSL-Material zur Bildung der Elektroden aufgebracht und diese durch Aufbringen der metallischen Schicht (1) miteinander verbunden werden.

4. Verfahren nach Anspruch 3, **dadurch gekennzeichnet, daß** als Material zur Bildung der zusätzlichen Schicht (5) LaAlO₃ gewählt wird.

5. Verwendung des HTSL-SNS-Kontaktes nach einem der Ansprüche 1 oder 2 in einem SQUID.

6. Verwendung des HTSL-SNS-Kontaktes nach einem der Ansprüche 1 oder 2 in einem Mehrfach-SNS-Kontakt.

## Claims

1. Superconductor-normalconductor-superconductor (SNS) contact with superconducting areas of high temperature superconductor (HTSL) material and with a metallic layer (1) which interconnects two superconducting layer areas (2) of HTSL material, which are separated from each other on a substrate (4) over a substrate step having a flank (3) and which serve as electrodes, **characterised in that** the flank of the substrate step (3) is covered by an additional layer (5) in such a manner that a growth of superconducting material at the flank (3) which is covered by the additional layer is prevented.

2. HTSL-SNS-contact according to Claim 1, **characterised in that** a precious metal is chosen as material of the metallic layer (1).

3. Process for the manufacture of an HTSL-SNS-contact according to Claim 1 or 2, **characterised in that** material for forming the additional layer (5) is applied to the stage of the substrate (4) in the area of the flank (3) in such a manner that the flank is covered by the additional layer (5), and this material is then partially removed in the area of the two substrate areas which are separated by the slanted flank, and thereafter HTSL material is applied for forming the electrodes, and the latter are joined together by application of the metallic layer (1).

4. Process according to Claim 3, **characterised in that** LaAlO₃ is chosen as material for forming the additional layer (5).

5. Use of the HTSL-SNS-contact according to one of Claims 1 or 2 in a SQUID.

6. Use of the HTSL-SNS-contact according to one of Claims 1 or 2 in a multiple-SNS-contact.

## Revendications

1. Contact supraconducteur-conducteur normal-supraconducteur (SNS) comportant des régions supraconductrices formées d'un matériau supraconducteur à haute température (HTSL) et comportant une couche métallique (1), qui relie entre elles deux régions de couches supraconductrices (2) formées d'un matériau HTSL, agissant en tant qu'électrodes et situées sur le substrat (4) en étant séparées les unes des autres par une partie étagée du substrat possédant un flanc (3), caractérisé en ce que le flanc de la partie étagée (3) du substrat est recouvert d'une couche supplémentaire (5) de telle sorte qu'une croissance d'un matériau supraconducteur sur le flanc (3) recouvert par la couche supplémentaire est empêchée.

2. Contact HTSL-SNS selon la revendication 1, caractérisé en ce qu'on choisit comme matériau de la couche métallique (1) un métal précieux.

3. Procédé pour fabriquer un contact HTSL-SNS selon la revendication 1 ou 2, caractérisé en ce qu'on dépose un matériau pour former la couche supplémentaire (5) sur la partie étagée du substrat (4) dans la zone du flanc (3) de telle sorte que le flanc est recouvert, de cette manière, par la couche supplémentaire (5) de sorte qu'on élimine alors partiellement ce matériau dans la zone des deux régions du substrat séparées par le flanc oblique, qu'on dépose ensuite le matériau HTSL pour former les électrodes et qu'on relie ces dernières entre elles au moyen du dépôt de la couche métallique (1).

4. Procédé selon la revendication 3, caractérisé en ce qu'on choisit du LaAlO₃ comme matériau servant à former la couche supplémentaire (5).

5. Utilisation du contact HTSL-SNS selon l'une des revendications 1 ou 2, dans un SQUID.

6. Utilisation du contact HTSL-SNS selon l'une des revendications 1 ou 2, dans un contact SNS multiple.
